# FASCICULE DE BREVET EUROPEEN

(11) **EP 0 561 706 B1**
(45) Date de publication et mention de la délivrance du brevet: **10.06.1998**
(21) Numéro de dépôt: 93400693.3
(22) Date de dépôt: 18.03.1993
(51) Int. Cl.: H04B 10/14, H01S 3/00, H04B 10/24

(54) **Emetteur-récepteur à détection cohérente**
Sender/Empfänger mit kohärenter Detektion
Emitter/receiver with coherent detection

(30) Priorité: 20.03.1992 FR 9203382
(43) Date de publication de la demande: 22.09.1993
(73) Titulaire: FRANCE TELECOM, 75015 Paris (FR)
(72) Inventeur: Nakajima, Hisao, F-92220 Bagneux (FR)
(74) Mandataire: Signore, Robert

(56) Documents cités:
- EP-A- 0 420 742
- FR-A- 2 662 883
- PATENT ABSTRACTS OF JAPAN vol. 15, no. 470 (E-1139)1991 & JP-A-32 03 268
- PATENT ABSTRACTS OF JAPAN vol. 13, no. 476 (E-837)1989 & JP-A-11 87 889

## Description

### Domaine technique

La présente invention a pour objet un émetteur-récepteur à détection cohérente et une liaison optique bidirectionnelle utilisant un tel émetteur-récepteur.

L'invention trouve des applications générales en télécommunications optiques.

### Etat de la technique antérieure

Les récepteurs à détection cohérente nécessitent un oscillateur local, un mélangeur optique et un photodétecteur quadratique (en général une photodiode). Cette partie optique du récepteur est complétée par des circuits électroniques assurant la récupération des signaux d'origine.

Les efforts déployés depuis de nombreuses années ont consisté à intégrer les trois composants optiques sur un substrat commun. On peut se reporter à cet égard à l'article de H. TAKEUCHI et al. intitulé "Monolithic integrated coherent receiver on InP substrate", publié dans IEEE Photon. Tech. Lett., 1, pp. 398-400 (1989) et à l'article de T.L. KOCH et al. intitulé "Balanced operation of a GaInAs/GaInAsP multiple-quantum-well integrated heterodyne receiver", publié dans IEEE Photon. Tech. Lett., 2, pp. 577-580 (1990).

Ces dispositifs intégrés, dits "Photonic Integrated Circuits" ou PIC en abrégé, ont permis d'augmenter la fiabilité, la compacité et la simplicité des installations de télécommunications optiques. Mais, ils comprennent encore un émetteur et un récepteur distincts, même si ces composants sont intégrés à une même structure. Or, il serait avantageux de n'utiliser qu'un seul composant servant à la fois d'oscillateur local et de récepteur. C'est ce qu'ont proposé R.F. KAZARINOV et al. dans un article intitulé "Heterodyne reception of light by an injection laser", publié dans Sov. Phys. JETP, 39, pp. 522-527 (1974).

Dans un dispositif unique de ce genre, on détecte la variation temporelle de la densité de porteurs due au battement du signal injecté dans la couche active du laser avec la lumière propre du laser (lequel est utilisé comme oscillateur local). Pour cela, on mesure la variation de tension aux bornes du laser. Ce principe a été testé en effectuant une réception cohérente en modulation ASK ("Amplitude Shift Keying") dans un laser à réflecteur de BRAGG (DBR) à multipuits quantiques (MQW). C'est ce qui est décrit dans l'article de R.A. LINKE et al. intitulé "Self-oscillating optical mixer receiver", publié dans OFC'89, paper WN4, 1989.

Une sensibilité de -36,6 dBm a été obtenue à 400 Mb/s avec un émetteur composé d'un laser à cavité externe et d'un modulateur externe.

Le document EP-A-0 420 742 décrit un photorécepteur pour signaux optiques modulés en fréquence. Ce photorécepteur consiste en un laser à semiconducteur alimenté nettement au-dessus du seuil. Le signal optique à démoduler est injecté dans le laser. La tension prélevée aux bornes de celui-ci reflète l'écart de fréquence entre la fréquence du signal et la fréquence propre du laser.

Ces techniques connues présentent cependant encore des inconvénients. En effet, si la technique de l'intégration photonique est conceptuellement la plus simple, elle est en revanche techniquement très difficile à mettre en oeuvre. Le surcoût dû à cette complexité rend cette technique inappropriée aux réseaux commerciaux. Quant à l'idée de détecter la modulation des porteurs causée par un battement dans un laser DBR, elle est séduisante, mais la variation de tension est faible et nécessite une amplification électriquement très importante (plus de 60 dB).

### Exposé de l'invention

La présente invention a justement pour but de remédier à ces inconvénients. A cette fin, elle propose une structure semiconductrice unique, très simple de mise en oeuvre et qui conduit à une sensibilité améliorée. Pour une puissance optique injectée de -35 dBm environ, un signal à 15 dB au-dessus du niveau de bruit a été mesuré. Le dispositif est par ailleurs de faible encombrement ((0,1x0,1x0,6)mm³).

Ces résultats sont obtenus par un émetteur-récepteur conformément aux caractéristiques de la revendication 1. Cet émetteur-récepteur comprend une structure semiconductrice à couche active et à réaction distribuée (DFB) et à déphaseur λ/4, avec une électrode centrale disposée au-dessus du déphaseur et deux électrodes latérales alimentées en courant au-dessus du seuil. Ce dispositif se comporte à la fois comme un oscillateur local (qui fonctionne à une fréquence Fo) et comme un photorécepteur à l'égard d'un signal optique reçu, qui est à une fréquence Fi. L'écart entre Fi et Fo doit être supérieur à la bande de verrouillage pour éviter que le photorécepteur ne se câle sur la fréquence incidente. Il existe alors simultanément trois signaux à trois fréquences différentes Fo, Fo+dF, Fo-dF (avec dF=Fi-Fo). Les signaux aux fréquences Fo+dF et Fo-dF sont amplifiés par un processus de mélange à quatre ondes. En prélevant la tension apparaissant sur l'électrode centrale et en la traitant comme en détection hétérodyne, on détecte le battement de ces fréquences, qui est une fonction sinusoïdale de l'écart dF, ce qui restitue l'information ayant modulé le signal optique incident.

Cette détection hétérodyne présente une meilleure sensibilité que dans le cas d'une simple photodiode, qui recevrait un signal optique incident et une onde provenant d'un laser local. Cette augmentation de sensibilité est due, d'une part, à ce que, dans la structure DFB à déphaseur, la puissance optique est concentrée dans la zone du déphaseur, là où précisément se trouve l'électrode de prélèvement de tension, et, d'autre part, à ce qu'une amplification optique s'établit, par le jeu du mélange à quatre ondes.

Le dispositif de l'invention est capable de travailler en modulation de fréquence (FSK), d'amplitude (ASK) ou de phase (PSK).

La présente invention a également pour objet une liaison optique bidirectionnelle utilisant deux émetteurs-récepteurs tels qu'ils viennent d'être décrits.

Le laser décrit dans le document EP-A-0 420 742 ne comporte pas, dans la région centrale du reseau, une zone introduisant un déphasage optique, ni une électrode centrale disposée au-dessus de cette région centrale, ni deux électrodes latérales disposées de part et d'autre de cette électrode centrale et électriquement isolées de celle-ci. Par ailleurs, l'écart de fréquence entre la fréquence du rayonnement incident et la fréquence propre du laser n'est pas supérieur à la largeur de la bande de verrouillage dans laquelle la fréquence de l'émission laser se verrouillerait sur la fréquence du faisceau optique incident.

### Brève description des dessins

- la figure 1 illustre un émetteur-récepteur selon l'invention ;
- la figure 2 montre la répartition des fréquences ;
- la figure 3 montre les variations de la puissance optique le long de la couche active ;
- la figure 4 montre l'allure du signal hétérodyne détecté en fonction de la différence de fréquence pour un signal non modulé (a) et pour un signal modulé en FSK (b) ;
- la figure 5 montre quelques exemples de réalisation d'un déphaseur ;
- la figure 6 montre un détail de réalisation de la structure semiconductrice ;
- la figure 7 illustre une liaison bidirectionnelle utilisant deux émetteurs-récepteurs conformes à l'invention.

### Exposé détaille de modes de réalisation

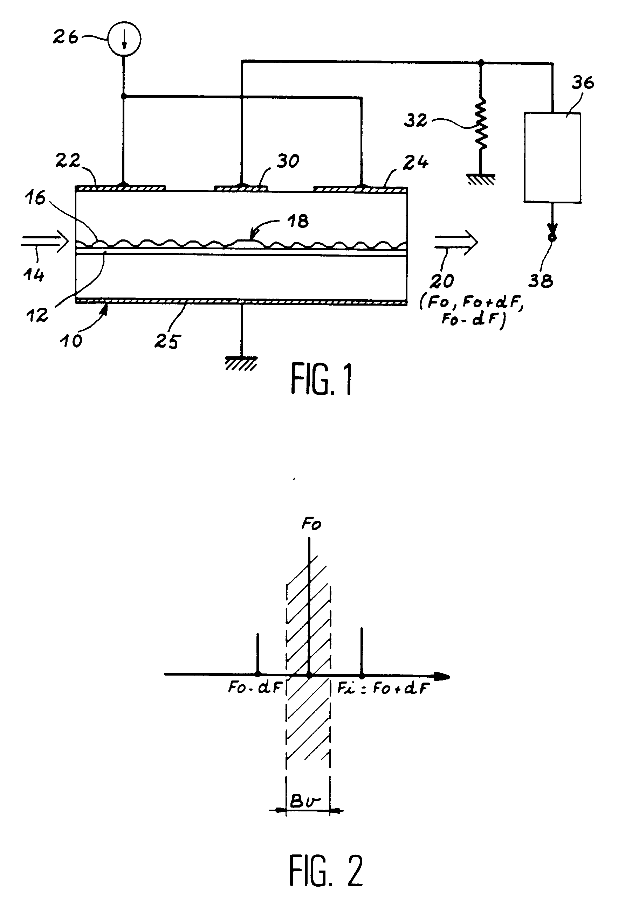

L'émetteur-récepteur représenté sur la figure 1 comprend une structure semiconductrice 10 à contre-réaction distribuée (DFB) composée d'un empilement de couches dont une couche active 12 recevant un faisceau optique 14 à la fréquence Fi. La structure comprend encore un réseau de diffraction 16 optiquement couplé à la couche active 12. Ce réseau 16 comporte une région centrale 18 introduisant un déphasage optique.

Les moyens pour prélever la tension aux bornes de cette structure sont constitués par une électrode centrale 30 disposée au-dessus de la région centrale 18 du réseau introduisant un déphasage optique.

Par ailleurs, deux électrodes latérales 22, 24 sont disposées de part et d'autre de l'électrode centrale 30 et électriquement isolées de celle-ci. Ces deux électrodes 22 et 24 sont reliées en parallèle à une source de courant 26 qui alimente la structure au-dessus du seuil laser. Naturellement, on pourrait éventuellement alimenter séparément ces deux électrodes.

Une électrode 25 est en outre disposée sous la structure et est reliée par exemple à la masse.

L'électrode de prélèvement 30 est reliée à une résistance 32 et à un circuit 36 de détection hétérodyne. Le plot de sortie 38 constitue la sortie du récepteur.

Etant alimentée au-dessus du seuil laser, la structure semiconductrice se comporte comme un laser émetteur. Ce laser possède une fréquence propre Fo. Comme déjà indiqué, la fréquence Fi du signal optique incident 14 doit être située hors de la plage de verrouillage (ou d'accrochage ou, en terminologie anglosaxonne, de "locking"). Dans cette plage, comme on le sait, l'oscillation du laser serait forcée sur la fréquence du signal incident ce qui ne conviendrait pas. En effet, dans la présente invention, on veut travailler en détection cohérente et il est donc essentiel qu'un laser local soit constitué, avec sa fréquence propre. Pour cette raison, il est nécessaire, d'une part, d'alimenter la structure au-dessus du seuil et, d'autre part, de veiller à ce que l'écart dF entre la fréquence Fi du signal incident et la fréquence propre Fo du laser soit suffisamment grand pour éviter l'accrochage.

Cette disposition des diverses fréquences est représentée sur la figure 2 où l'on voit la fréquence propre du laser Fo et les fréquences de battement à Fo-dF et Fo+dF où dF=Fi-Fo. La bande de verrouillage à éviter est la bande hachurée de largeur Bv.

Lorsque cette condition est respectée, un mélange à quatre ondes se produit dans le laser et le laser émet de la lumière aux fréquences Fo, Fo+dF et Fo-dF. Les champs aux fréquences Fo+dF et Fo-dF sont optiquement amplifiés par un processus de mélange à quatre ondes tel qu'il a été décrit par H. NAKAJIMA et R. FREY, dans un article intitulé "Intracavity nearly degenerate four-wave mixing in a (GaAl)As semiconductor laser", publié dans Appl. Phys., Lett., 47, pp. 769-771 (1985).

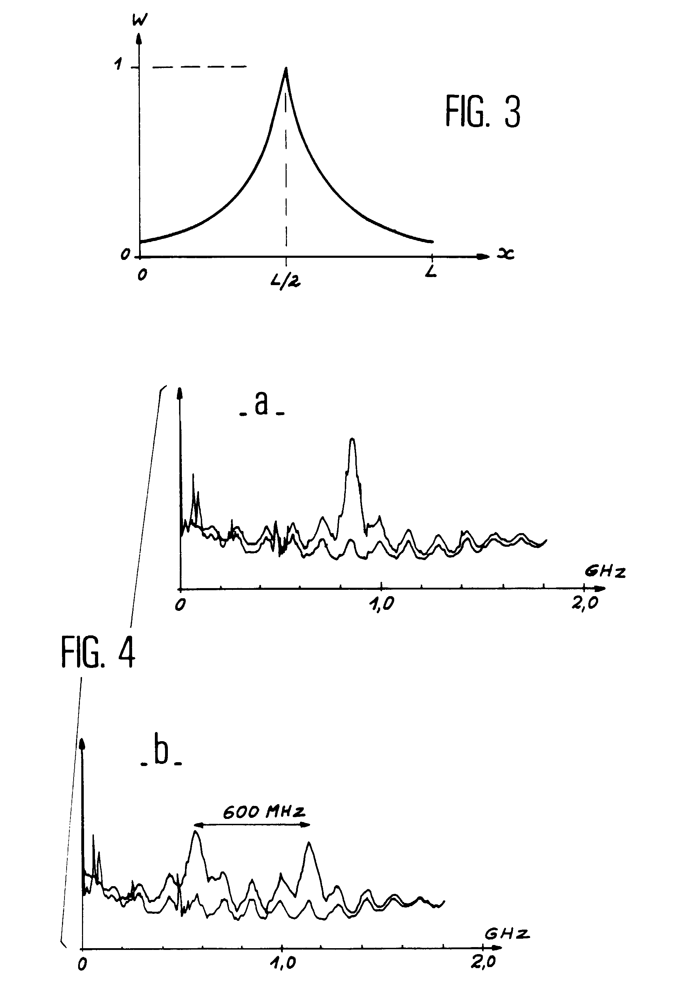

La détection par l'électrode centrale 30 est rendue plus efficace que dans une photodiode par le fait que, dans un laser DFB à déphasage, la puissance optique a tendance à se concentrer dans le centre de la structure. Ce phénomène est illustré sur la figure 3. On y voit la puissance optique W (en unités arbitraires) en fonction de la distance x le long de la couche active. La cavité laser est supposée avoir une longueur L. Un maximum très marqué se présente dans la zone centrale d'abscisse L/2.

La figure 3 correspond à un coefficient KL d'environ 4 où K est le coefficient de couplage du réseau avec la couche active et L la longueur de la cavité laser.

La figure 4 montre les signaux hétérodynes en fonction de la différence de fréquence (dF) pour un signal non-modulé (partie a) et un signal modulé en FSK (Frequency Shift Keying) (partie b).

Sur cette figure 4, l'écart de fréquence figure en abscisses et varie de 0 à 2 GHz. Chaque division vaut donc 200 MHz. L'écart de fréquence dF est d'environ 800 MHz (figure a). La modulation en FSK correspond à 200 Mbits/s et l'excursion de fréquence est de 600 MHz. Sur la figure b, on voit deux pics correspondant à un "1" et un "0" logiques, séparés de 600 MHz.

L'une des caractéristiques de l'invention est la présence, au-dessous de l'électrode de prélèvement de tension, d'un déphaseur. Ce déphaseur peut être de tout type connu. De nombreux exemples de réalisation ont été décrits dans la littérature, notamment dans les articles suivants :
- K. SEKARTEDJO et al., "1.5 µm phase-shifted DFB lasers for single-mode operation", Electron. Lett., 20, pp. 80-81, (1984),
- M. GILLERON et al., "1.5 µm phase-shifted distributed feedback laser", J. Physique, Colloque C4, supplément au n°9, tome 49, sept. 1988,
- T. MATSUYAMA et al., "TM mode suppression property of DFB lasers with a narrow stripe region", IEEE Photonics Techn. Lett. 2, pp. 612-613, (1990).

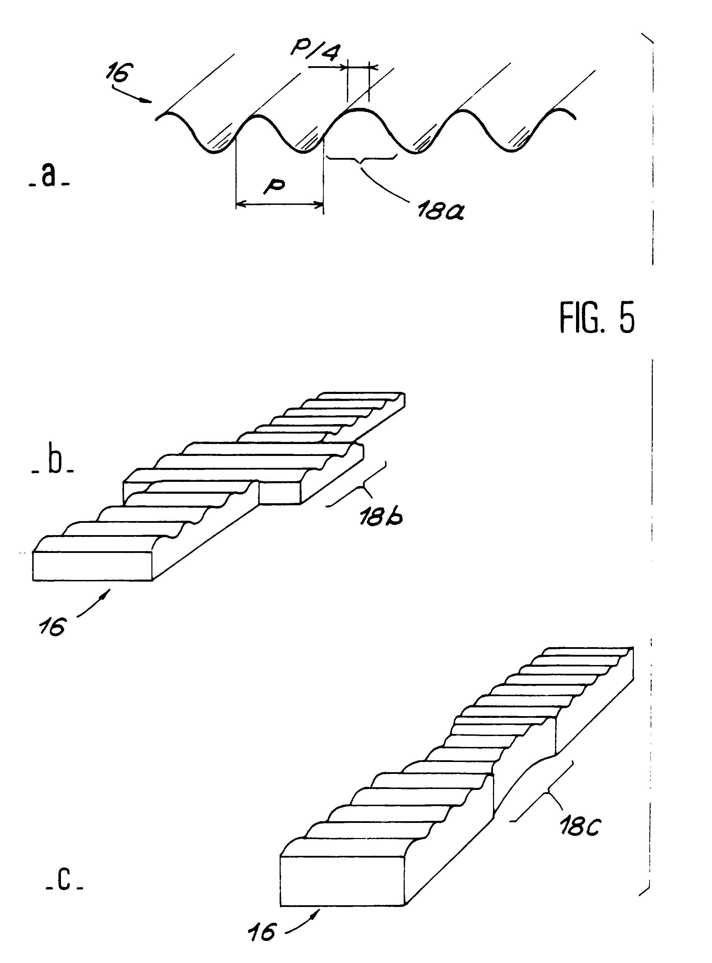

Trois exemples de déphaseurs sont illustrés sur la figure 5, mais il va de soi que ces exemples ne limitent en rien la portée de l'invention.

Sur la partie a, on voit, schématiquement représenté, un réseau de diffraction 16 avec sa surface présentant une ondulation périodique de pas p. Dans la zone centrale 18a, ce pas est allongé d'un quart de pas (p/4) ce qui introduit un déphasage optique d'un quart de longueur d'onde pour une onde cheminant le long du réseau, dans un sens ou dans l'autre. Naturellement, on pourrait aussi raccourcir le réseau d'un quart de pas.

Sur la partie b, on voit un réseau 16 au pas régulier mais présentant, dans la zone centrale 18b, une partie élargie. La longueur de la zone élargie correspond à un déphasage optique d'un quart de longueur d'onde.

Sur la partie c, au contraire, le réseau présente une zone 18c rétrécie.

Tous ces déphaseurs peuvent être utilisés dans l'invention.

Pour réaliser la structure de l'invention, tout procédé connu convient. On peut, par exemple, utiliser une technique dite du ruban enterré (Buried Ridge Stripe). Une telle technique est décrite dans l'article de J. CHARIL et al. intitulé "Extremely low threshold operation of 1.5 µm GaInAsP/InP buried ridge stripe lasers", publié dans Electron. Lett., 25, pp. 1477-1479, (1989).

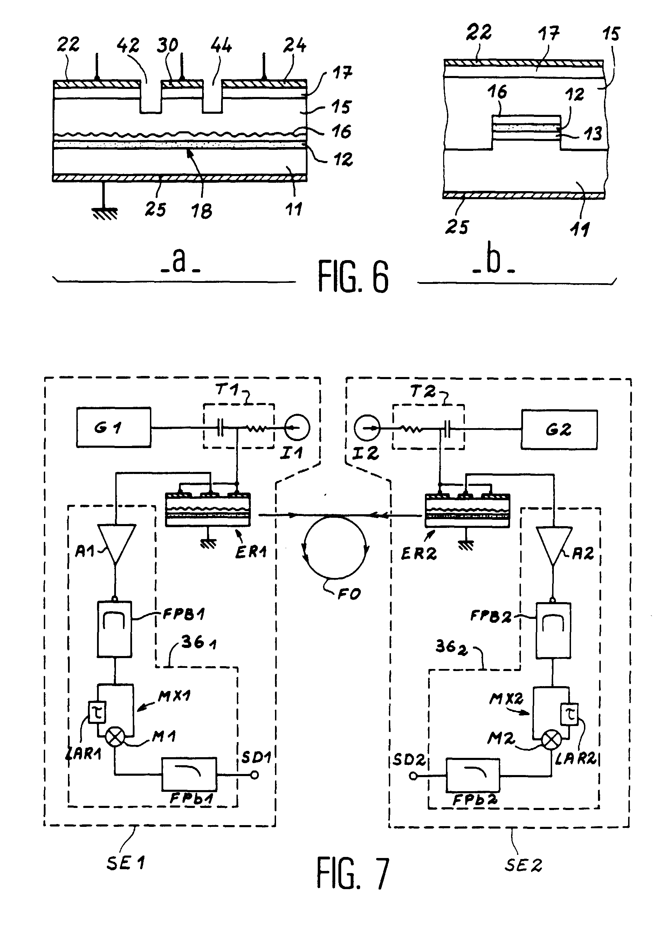

Ce mode de réalisation, qui n'est en rien limitatif de l'invention, est illustré sur la figure 6, en coupe longitudinale (a) et en coupe transversale (b). On y retrouve des éléments déjà représentés sur la figure 1 et qui portent les mêmes références, à savoir, la couche active 12, le réseau 16, les électrodes latérales 22 et 24, l'électrode inférieure 25, l'électrode centrale 30. On voit, en outre, que les électrodes 22, 24, d'une part, et 30, d'autre part, sont séparées par deux coupures 42 et 44 obtenues par gravure. Par ailleurs, on voit sur la partie (b), que la couche active 12 est située dans un ruban enterré dans une couche 15. La couche active 12 peut reposer sur une couche de confinement 13, elle-même reposant sur un substrat 11. Enfin, une couche semiconductrice très dopée 17 est intercalée entre les électrodes supérieures 22, 24, 30 et la couche 15.

A titre d'exemple, la couche active 12 peut être réalisée au moyen d'un empilement de couches constituant une structure à multipuits quantiques ("Multiple Quantum Wells" ou MQW) centrée sur la longueur d'onde de 1,5 µm. Le substrat 11 peut être en InP dopé N, la couche de confinement 13 peut être centrée sur une longueur d'onde de 1,3 µm ainsi que la couche 15, le tout en InP dopé P. La couche 17 peut être en InP dopé P⁺.

La présente invention a également pour objet une liaison optique bidirectionnelle. Cette liaison est représentée sur la figure 7. Elle comporte un premier sous-ensemble SE1, une fibre optique F0 et un second sous-ensemble SE2. Ces deux sous-ensembles sont identiques et comprennent les mêmes moyens référencés par une lettre affectée d'un indice 1 pour le premier et d'un indice 2 pour le second.

Le premier sous-ensemble SE1 comprend ainsi un émetteur-récepteur ER1 conforme à celui de la figure 1 et un circuit de traitement hétérodyne 36₁ relié à l'électrode centrale de prélèvement de tension. Une source de courant I1 est reliée aux électrodes latérales d'alimentation à travers un Té de polarisation T1 constitué par un condensateur et une inductance. Un générateur d'informations G1 est apte à moduler le courant du laser pour moduler sa fréquence d'émission. L'intensité du courant délivré par I1 est réglée au-dessus du seuil du laser.

Le circuit 36₁ comprend un amplificateur A1, un filtre passe bande FPB1, permettant d'extraire la partie utile du signal, un discriminateur MX1 avec une ligne à retard LAR1 et un multiplieur M1 et enfin un filtre passe bas FPb1. Le signal de démodulation apparaît sur la sortie SD1.

La configuration du système de la figure 7 est parfaitement symétrique.

Pour obtenir un fonctionnement stable, un circuit de stabilisation de la fréquence intermédiaire peut être également utilisé. Etant donné que ce circuit est un circuit hétérodyne comme les autres, il n'a pas à être décrit plus avant.

## Revendications

1. Emetteur-récepteur à détection cohérente, caractérisé par le fait qu'il comprend :
- une structure semiconductrice (10) à contre-réaction distribuée (DFB) composée d'un empilement de couches dont une couche active (12) et un réseau de diffraction (16) optique couplé à au moins une partie de la couche active (12), ce réseau (16) comportant une région centrale (18) introduisant un déphasage optique, la couche active (12) étant apte à recevoir un signal optique incident (14) modulé par une information autour d'une fréquence Fi lorsque l'émetteur-récepteur travaille en récepteur,
- une électrode centrale (30) disposée au-dessus de la région centrale (18) du réseau introduisant un déphasage optique,
- deux électrodes latérales (22, 24) disposées de part et d'autre de l'électrode centrale (30) et électriquement isolées de celle-ci,
- une source de courant (26) reliée aux deux électrodes latérales (22, 24) et alimentant la structure semiconductrice au-dessus du seuil, une émission laser étant apte à se produire à une fréquence Fo qui est la fréquence propre de la structure, l'écart de fréquence dF entre la fréquence incidente Fi et la fréquence propre Fo étant supérieur à la largeur (Bv) de la bande de verrouillage dans laquelle la fréquence de l'émission laser se verrouillerait sur la fréquence du faisceau optique incident, la source (26) produisant un courant modulable par un générateur d'informations (G1), lorsque l'émetteur-récepteur travaille en émetteur,
- des moyens électroniques (36) de type hétérodyne reliés à l'électrode centrale (30) et aptes à traiter le signal électrique prélevé et à délivrer un signal démodulé (SD) restituant l'information ayant modulé le signal optique incident (14) lorsque l'émetteur-récepteur travaille en récepteur.

2. Emetteur-récepteur selon la revendication 1, caractérisé par le fait que la couche active (12) est du type à multipuits quantiques.

3. Emetteur-récepteur selon la revendication 1, caractérisé par le fait que la région centrale (18) du réseau (16) introduisant un déphasage est une zone où le pas du réseau est localement diminué ou allongé (18a), ou une zone où la largeur du réseau est augmentée (18b) ou diminuée (18c), le pas restant constant.

4. Emetteur-récepteur selon la revendication 1, caractérisé par le fait que les moyens électroniques (36) comprennent un amplificateur à haute fréquence (A1, A2), un filtre passe-bande (FPB1, FPB2) centré sur l'écart (dF) entre la fréquence incident Fi et la fréquence propre Fo du laser, un discriminateur de fréquence (MX1, MX2) et un filtre passe-bas (FPbl, FPb2).

5. Liaison optique bidirectionnelle comprenant un premier ensemble émetteur-récepteur (SE1), une ligne de transmission optique (FO) et un second ensemble émetteur-récepteur (SE2), caractérisée par le fait que le premier et second ensembles émetteurs-récepteurs (SE1, SE2) comprennent chacun l'émetteur-récepteur de la revendication 1.

## Patentansprüche

1. Sender/Empfänger mit kohärenter Detektion,
**dadurch gekennzeichnet**, daß er umfaßt:
- eine Halbleiterstruktur (10) mit verteilter Rückkopplung (DFB), gebildet durch einen Schichtenstapel mit einer aktiven Schicht (12) und einem optischen Beugungsgitter (16), gekoppelt mit wenigstens einem Teil der aktiven Schicht (12), wobei dieses Gitter (16) einen zentralen Bereich (18) umfaßt, der eine optische Phasenverschiebung einführt, und die aktive Schicht (12) fähig ist, ein eintreffendes, durch eine Information um eine Frequenz Fi herum moduliertes optisches Signal (14) zu empfangen, wenn der Sender/Empfänger als Empfänger arbeitet,
- eine zentrale Elektrode (30), angeordnet über dem zentralen Bereich (18) des eine optische Phasenverschiebung einführenden Gitters,
- zwei seitliche Elektroden (22, 24), angeordnet beiderseits der zentralen Elektrode (30) und elektrisch von dieser isoliert,
- eine Stromquelle (26), verbunden mit den beiden seitlichen Elektroden (22, 24), welche die Halbleiterstruktur über dem Schwellenwert versorgt, was zu einer Laseremission mit einer Frequenz Fo befähigt, die die Eigenfrequenz der Struktur ist, wobei der Frequenzabstand dF zwischen der eintreffenden Frequenz Fi und der Eigenfrequenz Fo größer ist als die Breite (Bv) des Verriegelungsbandes, in dem die Laseremissionsfrequenz sich auf der Frequenz des eintreffenden optischen Bündels verriegelte, und die Quelle (26) einen durch einen Informationsgenerator (G1) modulierbaren Strom erzeugt, wenn der Sender/Empfänger als Sender arbeitet,
- elektronische Einrichtungen (36) des Heterodyn- bzw. Überlagerertyps, verbunden mit der zentralen Elektrode (30) und fähig, das entnommene Signal zu verarbeiten und ein demoduliertes Signal (SD) zu liefern, das die Information wiederherstellt, die das eintreffende optische Signal moduliert hat, wenn der Sender/Empfänger als Empfänger arbeitet.

2. Sender/Empfänger nach Anspruch 1, dadurch gekennzeichnet, daß die aktive Schicht (12) vom Multipotentialtöpfe-Typ ist.

3. Sender/Empfänger nach Anspruch 1, dadurch gekennzeichnet, daß der zentrale Bereich (18) des eine Phasenverschiebung einführenden Gitters (16) eine Zone ist, wo die Gitterteilung lokal verkürzt oder verlängert ist (18a), oder eine Zone, wo die Breite des Gitters vergrößert (18b) oder verkleinert (18c) ist, wobei die Teilung gleich bleibt.

4. Sender/Empfänger nach Anspruch 1, dadurch gekennzeichnet, daß die elektronischen Einrichtungen (36) einen Hochfrequenzverstärker (A1, A2) umfassen sowie ein Bandfilter (FPB1, FPB2), zentriert auf den Abstand (dF) zwischen der eintreffenden Frequenz Fi und der Eigenfrequenz Fo des Lasers, einen Frequenzdiskriminator (MX1, MX2) und ein Tiefpaßfilter (FPb1, FPb2).

5. Optische Zweirichtungsverbindung, eine erste Sender/Empfänger-Einheit (SE1), eine optische Übertragungsleitung (FO) und eine zweite Sender/Empfänger-Einheit (SE2) umfassend,
**dadurch gekennzeichnet,**
daß die erste und die zweite Sender/Empfänger-Einheit (SE1, SE2) jeweils den Sender/Empfänger des Anspruchs 1 enthält.

## Claims

1. Coherent detection transceiver, characterized in that it comprises a distributed feedback (DFB) semiconductor structure (10) constituted by a stack of layers, including an active layer (12) and an optical diffraction grating (16) coupled to at least part of the active layer (12), said grating (16) having a central region (18) introducing an optical phase shift, the active layer (12) receiving an incident optical signal (14) modulated by an information around a frequency Fi when the transceiver operates as a receiver, a central electrode (30) placed above the central region (18) of the grating introducing an optical phase shift, two lateral electrodes (2, 24) on either side of the central electrode (30) and electrically insulated therefrom, a power supply (26) connected to the two lateral electrodes (22, 24) and supplying the semiconductor structure above the threshold, a laser transmission taking place at a frequency Fo, which is the natural frequency of the structure, the frequency difference dF between the incident frequency Fi and the natural frequency Fo exceeding the width (Bv) of the locking band in which the frequency of the laser transmission would be locked on the frequency of the incident optical beam and electronic means (36) of the heterodyne type connected to the central electrode (30) and able to process the tapped electrical signal and supply a demodulated signal (SD) restoring the information which has modulated the incident optical signal (14).

2. Transceiver according to claim 1, characterized in that the active layer (12) is of the multiple quantum well type.

3. Transceiver according to claim 1, characterized in that the central region (18) of the grating (16) introducing a phase shift is a region where the spacing of the grating is locally reduced or increased (18a), or a region where the width of the grating is increased (18b) or decreased (18c), the spacing remaining the same.

4. Transceiver according to claim 1, characterized in that the electronic means (36) comprise a high frequency amplifier (A1, A2), a band pass filter (FPB1, FPB2) centred on the difference (dF) between the incident frequency Fi and the natural frequency Fo of the laser, a frequency discriminator (MX1, MX2) and a low pass filter (FPbl, FPb2).

5. Bidirectional optical link comprising a first transceiver assembly (SE1), an optical transmission line (F0) and a second transceiver assembly (SE2), characterized in that the first and second transceiver assemblies (SE1, SE2) in each case comprise a transceiver according to claim 1.
